# EUROPEAN PATENT APPLICATION

(11) **EP 3 820 041 A1**
(43) Date of publication of application: **12.05.2021**
(21) Application number: 20202416.2
(22) Date of filing: 16.10.2020
(51) Int. Cl.: H02M 7/487, H02M 7/00

(54) **DRIVE HAVING MULTILEVEL INVERTER MODULES**

(30) Priority: 05.11.2019 US 201962930670 P
(71) Applicant: Carrier Corporation, Palm Beach Gardens, FL 33418 (US)
(72) Inventor: CHEN, Weilun Warren, East Hartford, Connecticut 06118 (US); ARNEDO, Luis, Farmington, Connecticut 06032 (US); LEE, Yongduk, East Hartford, Connecticut 06118 (US); CHANNEGOWDA, Parikshith B., East Hartford, Connecticut 06118 (US)
(74) Representative: Dehns

(57) **Abstract**

A drive 14 is configured to provide power to a load 16. The drive 14 includes a control unit 100 including a controller 102 and a driver 104 located on a first substrate 108; a power unit 200 including at least one inverter module 202 located on a second substrate 208; and an interconnect 300 coupling the control unit 100 and the power unit 200.

## Description

The subject matter disclosed herein generally relates to drives for loads and, more particularly, to a drive incorporating multilevel inverter modules.

A drive is an electronic device used to provide the proper electrical power to a load, such as a motor. In an HVAC environment, existing drives use 2-level inverter topology. When used in high-speed applications, this topology requires a large output filter to improve the output current quality. To reduce or eliminate the output filter, without increasing switching frequency, multilevel topologies can be used.

According to embodiment first aspect of the invention, a drive is configured to provide power to a load. The drive includes a control unit including a controller and a driver located on a first substrate; a power unit including at least one inverter module located on a second substrate; an interconnect coupling the control unit and the power unit. Optionally, the second substrate comprises a thermal management feature. Optionally, the second substrate comprises a metal core printed circuit board.

Optionally, the at least one inverter module is configured to convert DC power from a DC source to a multilevel AC waveform.

Optionally, the at least one inverter module comprises three inverter modules arranged in parallel with the DC source, the drive configured to output a 2-level, three phase AC waveform.

Optionally, the at least one inverter module comprises three inverter modules arranged in parallel with the DC source, the drive configured to output a 3-level, three phase AC waveform.

Optionally, the at least one inverter comprises six inverter modules, a first three of the inverter modules arranged in parallel with the DC source, each of a second three of the inverter modules being in series with a respective one of the first three of the inverter modules, the drive configured to output a 5-level, three phase AC waveform.

Optionally, the first three of the inverter modules are connected to the second three of the inverter modules by connections on the first substrate.

Optionally, the at least one inverter module is a modular device.

Optionally, the control unit further comprise a sensor configured to sense an electrical parameter of the power unit.

Optionally, the electrical parameter includes AC current.

Optionally, the electrical parameter includes DC voltage.

Technical effects of at least the preferred embodiments of the present invention include the provision of a drive utilizing modular inverter modules to adapt to various load demands.

The foregoing features and elements may be combined in various combinations without exclusivity, unless expressly indicated otherwise. These features and elements as well as the operation thereof will become more apparent in light of the following description and the accompanying drawings. It should be understood, however, that the following description and drawings are intended to be illustrative and explanatory in nature and non-limiting.

Certain preferred embodiments will now be described by way of example with reference to the accompanying figures in which like reference numerals indicate similar elements.
FIG. 1 depicts a system including a drive.
FIG. 2 depicts a drive.
FIG. 3 depicts an inverter module.
FIG. 4 depicts three inverter modules arranged to provide a 2-level or 3-level inverter.
FIG. 5 depicts six inverter modules arranged to provide a 5-level inverter.

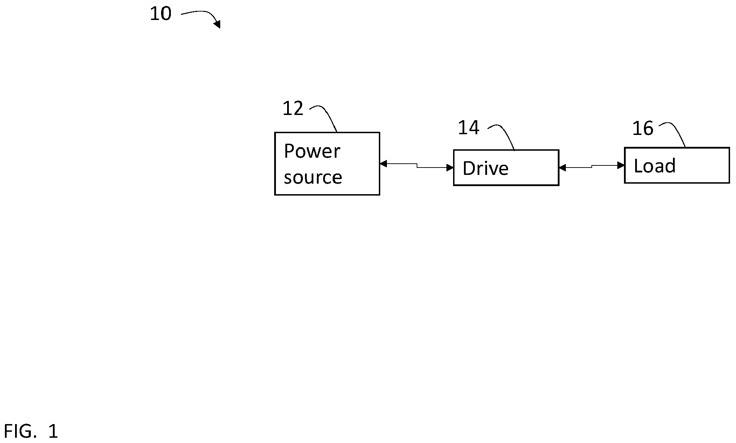

FIG. 1 depicts a system 10. The system 10 includes a power source 12, a drive 14 and a load 16. The power source may be a DC power source, such as a DC power supply, battery, capacitor, etc. The drive 14 is configured to convert the DC power from the DC power source 12 into one or more multilevel AC waveforms supplied to the load 16. The load 16 may be motor, such as a motor of a compressor in a refrigeration unit (e.g., a transport refrigeration unit on a container or trailer).

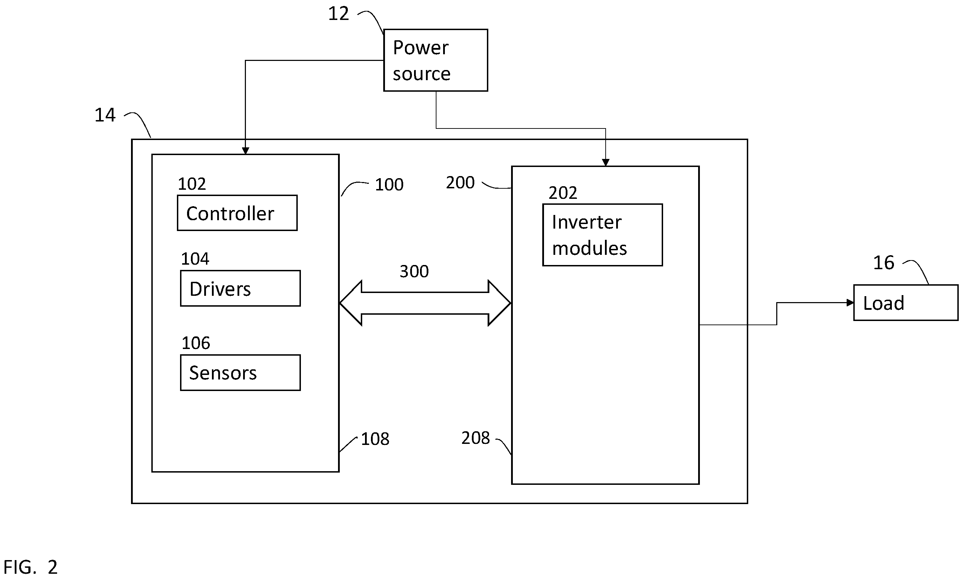

FIG. 2 depicts the drive 14 in more detail. The drive 14 includes a control unit 100 and a power unit 200. The control unit 100 includes a controller 102, drivers 104 and sensors 106. The controller 102 may be, but is not limited to, a single-processor or multiprocessor device of any of a wide array of possible architectures, including field programmable gate array (FPGA), central processing unit (CPU), application specific integrated circuits (ASIC), digital signal processor (DSP) or graphics processing unit (GPU) hardware arranged homogenously or heterogeneously. The controller 102 includes a memory that may be, but is not limited to, a random access memory (RAM), read only memory (ROM), or other electronic, optical, magnetic or any other computer readable medium. The memory may store executable instructions, that when executed by the processor, cause the controller 102 to perform operations described herein.

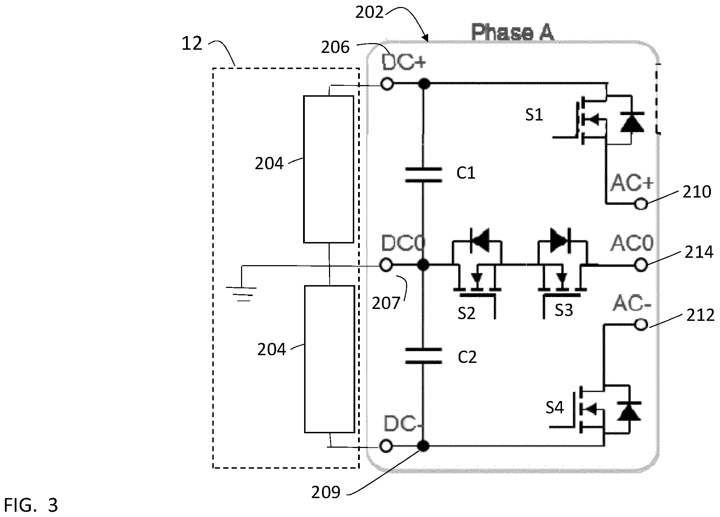

The drivers 104 may be implemented using power amplifiers that receive control signals from the controller 102 and provide drive signals to inverter modules 202 in the power unit 200. Sensors 106 may sense one or more electrical parameters of the power unit 200, such as AC current or DC voltage. The controller 102 receives the sensed electrical parameters from the sensors 106 to alter the control signals provided to the drivers 104. The power unit 200 includes one or more inverter modules 202, which are described in detail herein with reference to FIGs. 3-5.

The control unit 100 and the power unit 200 are formed on separate substrates. A first substrate 108 supports the controller 102, drivers 104 and sensors 106, and may be a printed circuit board (e.g., FR4). A second substrate 208 supports the inverter modules 202, and may be equipped with thermal management features. Optionally, the second substrate 208 is a metal core printed circuit board to improve dissipation of heat generated by the inverter modules 202. Other thermal management features may be employed on the second substrate 208 including heat sinks, fans, heat pipes, etc. The control unit 100 and the power unit 200 communicate over an interconnect 300, such as a ribbon cable, bus, etc.

FIG. 3 depicts an inverter module 202. The inverter module 202 depicted in this embodiment uses a neutral point clamped (NPC) topology. The inverter module 202 of FIG. 3 may be referred to as a T-type neutral point clamp (T-NPC) circuit. Power to the inverter module 202 may be provided by the power source 12 including a center-grounded battery 204, which provides a positive DC voltage at a positive node 206, a negative DC voltage at a negative node 209 and ground at a neutral node 207. The inverter module 202 includes capacitors C1 and C2, connected such that the anode of capacitor C1 is connected to the positive DC node 206, the cathode of the capacitor C1 is connected to the anode of the capacitor C2, and the cathode of the capacitor C2 is connected to the negative DC node 209.

Switches S1-S4 are controlled by drive signals from the drivers 104 to produce a multilevel AC waveform output by the inverter module 202 and supplied to load 16. A positive AC output terminal 210 provides the positive voltage of the AC waveform. A negative AC output terminal 212 provides the negative voltage of the AC waveform. A neutral AC output terminal 214 provides the neutral voltage of the AC waveform, if used.

Switches S1-S4 may be wideband devices (GaN MOSFETs), although IGBTs, IGCT's, or other similar types of high-voltage switches may be utilized. Switches S1-S4 are each associated with a diode. Each diode is connected with its cathode coupled to the drain and its anode coupled to the source of a switch, to serve as a freewheeling or flyback diode. FIG. 3 depicts an inverter module 202 that generates one phase of a multilevel AC waveform. If multiple phases are used by the load 16, then a separate inverter module 202 may be used for each phase.

In operation, the controller 102 provides control signals to the drivers 104. The drivers 104 provide drive signals to the gate terminals of the switches S1-S4 in order to produce a multilevel AC waveform at the output terminals 210 and 212, and optionally 214. When a 2-level AC waveform is desired, switches S2 and S3 are not controlled and are in a non-conductive state. When a 3-level AC waveform is desired, all of switches S1-S4 are controlled by the drive signals.

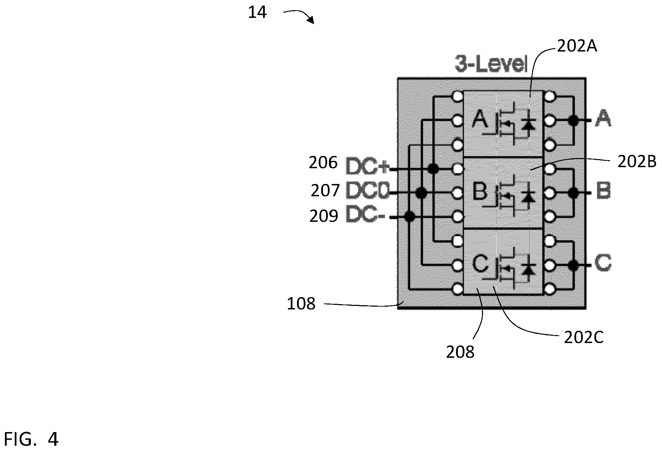

FIG. 4 depicts three inverter modules arranged to provide a three phase drive 14. Each inverter module 202A, 202B and 202C is similar to the inverter module 202 of FIG. 3. Inverter modules 202A, 202B and 202C may be mounted on a substrate 208, similar to substrate 208 of FIG. 2. Inverter modules 202A, 202B and 202C are arranged in parallel with the DC positive node 206, DC negative node 209 and DC neutral node 207. Inverter modules 202A, 202B and 202C each provide one phase of a three phase AC waveform. The output terminals 210, 212 and 214 of each inverter module 202A, 202B and 202C are connected together. If only switches S1 and S4 are controlled, then the drive 14 provides a 2-level, three phase AC waveform output. If all of switches S1-S4 are controlled, then the drive 14 provides a 3-level, three phase AC waveform output.

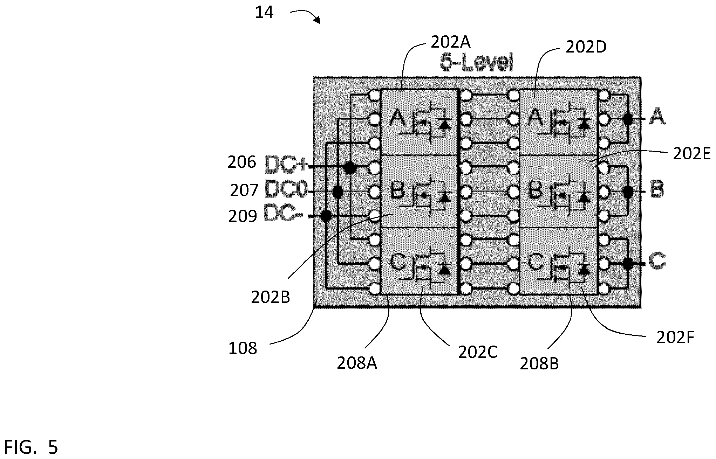

FIG. 5 depicts six inverter modules arranged to provide a 5-level, three phase drive 14. Inverter modules 202A, 202B and 202C are arranged in parallel with the DC positive node 206, DC negative node 209 and DC neutral node 207. The output terminals of each inverter module 202A, 202B and 202C are connected input terminals of inverter modules 202D, 202E and 202F, respectively, through a series-connected network of one or more capacitors. The output terminals 210, 212 and 214 of each inverter module 202D, 202E and 202F are connected together. Inverter modules 202A, 202B and 202C may be mounted on a substrate 208A, similar to substrate 208 of FIG. 2. Inverter modules 202D, 202E and 202F may be mounted on a substrate 208B, similar to substrate 208 of FIG. 2. The series capacitors interconnecting substrate 208A and substrate 208B may be provided on the first substrate 108. This allows substrate 208, with three inverter modules 202, to be used in a variety of configurations by simply altering the first substrate 108.

Each inverter module 202 may be implemented with a single IC package (e.g., through hole mounted, surface mounted), so that adding and removing inverter modules 202 from a drive 14 is simplified. Embodiments of the drive 14 are compact, modular and expandable depending on application needs. The combination of modular inverter modules 202 and substrate 208 allows a high-density, automated assembly process and improved heat conduction to heatsinks. The same substrate 208 design and construction can be reconfigured to produce 2-level, 3-level, 5-level or N-level AC waveforms depending on the drive requirements. This enables low-cost and highly flexible designs.

The terminology used herein is for the purpose of describing particular embodiments only and is not intended to be limiting of the present disclosure. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, element components, and/or groups thereof.

Those of skill in the art will appreciate that various example embodiments are shown and described herein, each having certain features in the particular embodiments, but the present disclosure is not thus limited. Rather, the present disclosure can be modified to incorporate any number of variations, alterations, substitutions, combinations, sub-combinations, or equivalent arrangements not heretofore described, but which are commensurate with the scope of the present invention, as defined by the claims. Accordingly, the present invention is not to be seen as limited by the foregoing description, but is only limited by the scope of the appended claims.

## Claims

1. A drive (14) configured to provide power to a load (16), the drive comprising:
a control unit (100) including a controller (102) and a driver (104) located on a first substrate (108);
a power unit (200) including at least one inverter module (202) located on a second substrate (208);
an interconnect (300) coupling the control unit and the power unit.

2. The drive of claim 1 wherein the second substrate (208) comprises a thermal management feature.

3. The drive of claim 1 or 2 wherein the second substrate (208) comprises a metal core printed circuit board.

4. The drive of claim 1, 2 or 3 wherein the at least one inverter module (202) is configured to convert DC power from a DC source to a multilevel AC waveform.

5. The drive of claim 4 wherein the at least one inverter module (202) comprises three inverter modules arranged in parallel with the DC source, the drive configured to output a 2-level, three phase AC waveform.

6. The drive of claim 4 wherein the at least one inverter module (202) comprises three inverter modules arranged in parallel with the DC source, the drive configured to output a 3-level, three phase AC waveform.

7. The drive of claim 4 wherein the at least one inverter module (202) comprises six inverter modules, a first three of the inverter modules arranged in parallel with the DC source, each of a second three of the inverter modules being in series with a respective one of the first three of the inverter modules, the drive configured to output a 5-level, three phase AC waveform.

8. The drive of claim 7 wherein the first three of the inverter modules (202) are connected to the second three of the inverter modules by connections on the first substrate (108).

9. The drive of any preceding claim wherein the at least one inverter module (202) is a modular device.

10. The drive of any preceding claim wherein the control unit (100) further comprise a sensor (106) configured to sense an electrical parameter of the power unit (200).

11. The drive of claim 10, wherein the electrical parameter includes AC current.

12. The drive of claim 10, wherein the electrical parameter includes DC voltage.
